# EUROPÄISCHE PATENTANMELDUNG

(11) **EP 2 884 295 A1**
(43) Veröffentlichungstag der Anmeldung: **17.06.2015**
(21) Anmeldenummer: 14003344.0
(22) Anmeldetag: 27.09.2014
(51) Int. Cl.: G01R 31/36, B60L 11/18, B60L 11/00, G05B 17/02

(54) **Systeme und Verfahren zum Entwickeln und Testen von hybriden Energiespeichern**

(30) Priorität: 13.12.2013 DE 102013021004
(71) Anmelder: MAN Truck & Bus AG, 80995 München (DE)
(72) Erfinder: Hofmann, Markus, 80636 München (DE)

(57) **Zusammenfassung**

Die Erfindung betrifft ein System zum Entwickeln, Optimieren und/oder Testen von hybriden Energiespeichern. Die Erfindung betrifft ferner ein Verfahren zum Entwickeln, Optimieren und/oder Testen von hybriden Energiespeichern. Das System umfasst eine Testanordnung und eine Simulationsvorrichtung. Die Testanordnung umfasst einen Emulator eines hybriden Energiespeichers, der mit dem Fahrbetriebsemulator zur Energieaufnahme und/oder Energieabgabe verbunden ist, umfassend: einen ersten Energiespeicheremulator (2), wenigstens einen zweiten Energiespeicheremulator (3) und eine Leistungselektronikeinheit (4), mittels der Energie in den ersten (2) und den wenigstens zweiten Energiespeicheremulator (3) zuführbar ist und mittels der Energie aus dem ersten (2) und dem zweiten (3) Energiespeicheremulator entnehmbar ist. Die Energiespeicheremulatoren (2, 3) sind jeweils einrichtbar, durch eine Variation von Energiespeicherparametern unterschiedliche Klassen von Energiespeichern und/oder unterschiedliche Betriebszustände eines Energiespeichers zu emulieren. Eine Steuerungseinrichtung (5) ist ausgebildet, die Leistungselektronikeinheit (4) zu steuern, wobei die Steuerungseinrichtung (5) einrichtbar ist, unterschiedliche Steuerungsverfahren durchzuführen. Die Simulationsvorrichtung (6) ist eingerichtet, den Betrieb von hybriden Energiespeichern mittels der Testanordnung für verschiedene Einrichtungen der Steuerungseinrichtung (5) und/oder verschiedene Energiespeicherparameter zu simulieren.

## Beschreibung

Die Erfindung betrifft ein System zum Entwickeln, Optimieren und/oder Testen von hybriden Energiespeichern. Die Erfindung betrifft ferner ein Verfahren zum Entwickeln, Optimieren und/oder Testen von hybriden Energiespeichern.

Bei Kraftfahrzeugen kommen zunehmend hybride Energiespeichersysteme zum Einsatz. Unter einem "hybriden Energiespeicher" versteht man die Kombination mindestens zweier Speicher mit vorzugsweise unterschiedlichen Eigenschaften. Hybride Energiespeichersysteme haben den Vorteil, dass diese besser auf die unterschiedlichen Leistungsanforderungen im Fahrbetrieb ausgelegt und optimiert werden können. So können in einem hybriden Energiespeicher beispielsweise ein Speicher mit hoher Energiedichte bzw. Speicherkapazität mit einem Speicher mit hoher Leistungsdichte kombiniert werden. Der Speicher mit hoher Energiedichte bzw. Speicherkapazität ermöglicht eine große Reichweite eines elektrisch angetriebenen Fahrzeugs; der Speicher mit hoher Leistungsdichte ist dagegen in der Lage, kurzzeitig hohe Energieflüsse, die beispielsweise bei einem Rekuperationsvorgang beim Bremsen entstehen, aufzunehmen.

Bei der Entwicklung derartiger hybrider Energiespeichersysteme besteht die Schwierigkeit, diese durch Wahl geeigneter Parameter für die unterschiedlichen Anforderungen im Fahrbetrieb optimal anzusteuern und auszulegen.

Die Intelligenz eines hybriden Speichers liegt in der Ansteuerung der Leistungselektronik zwischen den einzelnen Energiespeichern. Durch ein Steuergerät wird entschieden, aus welchem der Energiespeicher die Energie entnommen wird, die vom Fahrbetrieb aufgenommen wird, und in welchem Energiespeicher die vom Fahrbetrieb abgegebenen Energie gespeichert wird. Die Leistungselektronik, die die Energieflüsse zwischen den Energiespeichern steuert, wird dann entsprechend von dem Steuergerät angesteuert. Eine optimale Ansteuerung der Leistungselektronik kann beispielsweise diejenige sein, die den energieeffizientesten Betrieb des Fahrzeugs ermöglicht, und/oder diejenige, die den Verschleiß der Leistungsfähigkeit der Energiespeicher über deren Lebensdauer gering hält.

Die Auslegung des Steuergeräts hängt in der Regel von den verwendeten Energiespeichern und deren Auslegung sowie von den Anforderungen des fahrzeugspezifischen Fahrbetriebs ab, so dass es bei vielen Fahrzeugvarianten erforderlich ist, für die verschiedenen Varianten jeweils eine optimale Auslegung der Steuerung der Leistungselektronik für das hybride Energiespeichersystem zu bestimmen. Erschwerend kommt hinzu, dass sich die Eigenschaften eines Energiespeichers typischerweise dynamisch mit seinem Betriebszustand verändern. Beispielsweise verändert sich die Leistungsfähigkeit eines Energiespeichers mit dessen Alterungszustand, der wiederum von der Anzahl und Art der Lade- und Entladevorgänge abhängt, die wiederum von den Fahrbetriebsanforderungen und von der Auslegung der Steuerung der Energieflüsse beeinflusst werden.

Aus der Praxis sind zur Entwicklung von hybriden Energiespeichersystemen Ansätze bekannt, durch Testfahrten mit einem Testfahrzeug die Steuerung der Leistungselektronik und den Einfluss auf das Energiespeichersystem zu untersuchen. Derartige Ansätze sind jedoch sehr kosten- und zeitaufwändig, um unterschiedliche Auslegungen zu testen.

Es ist somit eine Aufgabe der Erfindung, eine verbesserte Möglichkeit bereitzustellen, um Nachteile herkömmlicher Ansätze zum Entwickeln und Testen von hybriden Energiespeichersystemen zu vermeiden. Die Aufgabe der Erfindung ist es insbesondere, ein System und ein Verfahren zum Entwickeln, Optimieren und Testen von hybriden Energiespeichersystemen bereitzustellen, mittels derer schnell und kosteneffektiv eine möglichst optimale Auslegung eines hybriden Energiespeichersystems bestimmt werden kann.

Diese Aufgaben werden durch ein System und ein Verfahren zum Entwickeln, Optimieren und/oder Testen von hybriden Energiespeichern mit den Merkmalen der unabhängigen Ansprüche gelöst. Vorteilhafte Ausführungsformen und Anwendungen der Erfindung sind Gegenstand der abhängigen Ansprüche und werden in der nachfolgenden Beschreibung unter teilweiser Bezugnahme auf die Figuren näher erläutert.

Gemäß allgemeiner Gesichtspunkte der Erfindung wird ein System mit einer Testanordnung vorgeschlagen, bei der der Energieverbrauch eines Fahrbetriebs und/oder eine Energieerzeugung des Fahrbetriebs sowie das Verhalten eines hybriden Energiespeichers jeweils durch Emulatoren nachgebildet werden, derart, dass diese mit einer Leistungselektronik und mit realen Strömen getestet werden können.

Die Testanordnung umfasst hierzu einen Fahrbetriebsemulator, der eingerichtet ist, einen Energieverbrauch und/oder eine Energieerzeugung eines Fahrbetriebs eines Kraftfahrzeugs zu emulieren. Der Fahrbetriebsemulator kann beispielsweise mit einer gesteuerten Leistungselektronik emuliert sein, nachfolgend auch als DC-Quelle/-Senke bezeichnet, die entsprechend einem Fahrbetriebsmodell so angesteuert wird, dass die DC-Quelle/-Senke entsprechend einem Energieverbrauch eines Fahrbetriebs Energieflüsse bzw. Strom aufnimmt und entsprechend einer Energieerzeugung eines Fahrbetriebs Energieflüsse bzw. Strom abgibt. Alternativ kann der Fahrbetriebsemulator auch durch einen "echten" Fahrantrieb gebildet sein, der gegen eine Belastungsmaschine betrieben wird, beispielsweise auf einem Prüfstand. Die Belastungsmaschine ist hierbei so ausgelegt, dass sie die typischen Belastungen eines Fahrbetriebs nachbildet und auch so betrieben werden kann, dass Vorgänge zur Energieerzeugung, beispielsweise Rekuperationsvorgänge, dargestellt werden können.

Die Testanordnung umfasst ferner einen Emulator eines hybriden Energiespeichers, der mit dem Fahrbetriebsemulator zur Energieaufnahme und/oder Energieabgabe verbunden ist. Der Emulator des hybriden Energiespeichers ist somit eingerichtet, zur Deckung des Energieverbrauchs des Fahrbetriebsemulators Energie bzw. Strom abzugeben und eine vom Fahrbetriebsemulator erzeugte Energie bzw. Strom aufzunehmen.

Der Emulator eines hybriden Energiespeichers umfasst hierbei einen ersten Energiespeicheremulator und wenigstens einen zweiten Energiespeicheremulator zur Nachbildung eines hybriden Energiespeichersystems mit wenigstens zwei Energiespeichern. Ferner ist eine Leistungselektronikeinheit vorgesehen, mittels der Energie in den ersten und den wenigstens zweiten Energiespeicheremulator zuführbar ist und mittels der Energie aus dem ersten und dem zweiten Energiespeicheremulator entnehmbar ist.

Der erste Energiespeicheremulator, der wenigstens eine zweite Energiespeicheremulator und die Leistungselektronik bilden somit einen hybriden Energiespeicher nach und können mit realen Energieflüssen bzw. Strömen betrieben und getestet werden.

Ein besonderer Vorzug der Erfindung liegt ferner darin, dass die Energiespeicheremulatoren jeweils einrichtbar sind, durch eine Variation von Energiespeicherparametern unterschiedliche Klassen von Energiespeichern, d. h. unterschiedliche Typen von Energiespeichern, und unterschiedliche Betriebszustände eines Energiespeichers zu emulieren.

Hierbei können die Energiespeicherparameter zumindest einen der folgenden Parameter des Energiespeichers umfassen: die Energiedichte, die Leistungsdichte, die Speicherkapazität und/oder den Ladezustand (SoC) des Energiespeichers. Durch Variation dieser Parameter können unterschiedliche Klassen von Energiespeichern und/oder verschiede Betriebszustände, z. B. verschiedene Alterungszustände eines bestimmen Energiespeichers einer Klasse, nachgebildet werden.

Ferner ist eine Steuerungseinrichtung vorgesehen, die ausgebildet ist, die Leistungselektronikeinheit zu steuern, derart, dass die Steuerungseinrichtung der Leistungselektronikeinheit vorgibt, aus welchen der Energiespeicheremulatoren Energie für den Fahrbetriebsemulator bereitgestellt wird und/oder in welchen der Energiespeicheremulatoren vom Fahrbetriebsemulator erzeugte Energie gespeichert wird. Hierbei ist die Steuerungseinrichtung ebenfalls einrichtbar, unterschiedliche Steuerungsverfahren durchzuführen, beispielsweise durch eine Variation von Steuerungsparametern oder allgemein der Auslegung der Steuerungseinrichtung.

Das System umfasst ferner eine Simulationsvorrichtung, die eingerichtet ist, den Betrieb der Testanordnung für verschiedene Einrichtungen der Steuerungseinrichtung und/oder verschiedene Energiespeicherparameter zu simulieren.

Ein besonderer Vorzug der Erfindung liegt somit darin, dass durch den Einsatz von Energiespeicheremulatoren die Kombination von unterschiedlichen Energiespeicherklassen in einem hybriden Energiespeichersystem und/oder unterschiedliche Betriebszustände von Energiespeichern durch geeignete Parametrisierung der Energiespeicheremulatoren nachgebildet werden können und mit einer Simulation unter Verwendung realer Ströme in Kombination mit der zu optimierenden Leistungselektronik und Steuerungseinrichtung getestet werden können. Ferner ermöglicht der Fahrbetriebsemulator verschiedene Lastanforderungen des Fahrbetriebs, beispielsweise verschiedene Fahrwiderstände und auch verschiedene Rekuperationsvorgänge in einer kontrollierten Testumgebung abzubilden, um vergleichbare Testergebnisse des hybriden Energiespeichers zu erzielen. Ferner ermöglicht das Testsystem, verschiedene Steuerverfahren zur Ansteuerung der Leistungselektronik zu testen, indem das im Steuergerät eingerichtete Steuerungsverfahren für verschiedene Testbetriebe variiert wird.

Gemäß einem bevorzugten Ausführungsbeispiel umfasst der erste Energiespeicheremulator und/oder der wenigstens eine zweite Energiespeicheremulator eine ansteuerbare DC-Quelle/-Senke. Programmierbare Spannungs-Strom-Quellen, die ein vorgegebenes Spannungsverhalten und Stromflüsse abbilden können, sind an sich aus dem Stand der Technik bekannt. Gemäß einer Ausführungsform der Erfindung erfolgt die Ansteuerung der DC-Quelle/-Senke mittels eines hinterlegten Energiespeichermodells. Das Energiespeichermodell modelliert die Eigenschaften und das Verhalten eines bestimmten Energiespeichers. Eine Steuerung steuert die DC-Quelle/-Senke in Echtzeit in Abhängigkeit des Energiespeichermodells.

Mit anderen Worten wird bei einer derartigen Energiespeichernachbildung eine Leistungselektronik, die eine DC-Quelle/-Senke ausbildet, von einer Echtzeitsteuerung so angesteuert, dass sie sich an ihren DC-Klemmen in Strom und Spannung so verhält wie ein bestimmter Energiespeicher. Hierfür werden der Strom und gegebenenfalls weitere Größen an den DC-Klemmen der Leistungselektronik gemessen und von der Steuerung als Eingangsgröße für ein hinterlegtes Energiespeichermodell des zugeordneten emulierten Energiespeichers verwendet. In Abhängigkeit des hinterlegten Energiespeichermodells und des gemessenen Stromwerts und gegebenenfalls weiterer Messgrößen kann dann eine Reaktion des emulierten Energiespeichers auf den gemessenen emulierten Lade- oder Entladevorgang in Form eines Sollwerts für die DC-Klemmspannung an die steuerbare DC-Quelle/-Senke vorgegeben werden. Auf diese Weise können verschiedene Speichertypen, d. h. Speicherklassen, sowie verschiedene Auslegungen eines bestimmten Speichers emuliert werden. Die Parameter der emulierten Energiespeicher lassen sich somit einfach und schnell verändern.

Die ansteuerbare DC-Quelle/-Senke und die Steuerung der DC-Quelle/-Senke mit dem hinterlegten Energiespeichermodell können in einer baulichen Einheit integriert sein.

Im Rahmen der Erfindung besteht ferner die Möglichkeit, die Funktionalität eines Energiespeicheremulators verteilt anzuordnen. Gemäß einer weiteren vorteilhaften Variante dieser Ausgestaltungsform ist ein Rechner vorgesehen, in dem die Energiespeichermodelle der emulierten Energiespeicher des hybriden Energiespeichers zentral hinterlegt sind und der Rechner über Signalleitungen jeweils mit den ansteuerbaren DC-Quelle/-Senken verbunden ist.

Über die Signalleitungen wird der an der DC-Klemme der jeweiligen DC-Quelle/-Senke gemessene Stromwert als Eingangsgröße für das hinterlegte jeweilige Energiespeichermodell an den Rechner übermittelt. Der Rechner bestimmt dann für jede DC-Quelle/-Senke in Abhängigkeit des jeweiligen Energiespeichermodells den Sollwert für die DC-Klemmenspannung und gibt diesen Sollwert über die Steuerleitung an die steuerbare DC-Quelle/-Senke vor. Dies hat den Vorteil, dass über einen zentralen Rechner alle DC-Quellen/-Senken gesteuert werden können. Der Rechner ist ein Echtzeitrechner, so dass die Energieflüsse mit realen Strömen in Echtzeit emuliert werden können.

Ferner kann der Rechner gleichzeitig genutzt werden, um an einer zentralen Stelle die Parametrisierung der Energiespeicheremulatoren anzupassen. In diesem Ausführungsbeispiel ist somit der zentrale Rechner Teil des emulierten Hybridspeichers, da in ihm die Speichermodelle hinterlegt sind und der Rechner als Steuerung der DC-Quelle/-Senke fungiert.

In der vorgenannten Ausführungsvariante mit einem zentralen Rechner, in dem jeweils die Energiespeichermodelle der einzelnen Energiespeicheremulatoren hinterlegt sind, kann der Rechner ferner so eingerichtet sein, um als die vorgenannte Simulationsvorrichtung betrieben zu werden. Der Rechner ist somit ferner eingerichtet, mittels einer Variation von Energiespeicherparametern in den hinterlegten Energiespeichermodellen den Betrieb von hybriden Energiespeichern mittels der Testanordnung für verschiedene Energiespeicherparameter zu simulieren. Dadurch können die Emulation des hybriden Energiespeichers und die Parametrisierung und Simulation des Gesamtsystems von einer zentralen Stelle aus gesteuert werden.

Gemäß einer weiteren Ausführungsvariante sind in dem zentralen Rechner ferner ein Fahrbetriebsmodell hinterlegt, das zur Steuerung einer Leistungselektronik des Fahrbetriebsemulators verwendet wird, um einen Energieverbrauch eines Fahrbetriebs vorzugeben, der aus dem hybriden Energiespeichersystem bedient werden muss, beziehungsweise eine Energieerzeugung eines Fahrbetriebs vorzugeben, wobei die erzeugte Energie von dem hybriden Energiespeichersystem aufgenommen wird.

Gemäß einem bevorzugten Ausführungsbeispiel ist der erste Energiespeicheremulator eingerichtet, einen Energiespeicher mit höherer Energiedichte und kleinerer Leistungsdichte als der zweite Energiespeicheremulator zu emulieren. Dadurch kann eine der gängigsten Arten von hybriden Speichersystemen nachgebildet werden, um sowohl eine hohe Energiegesamtmenge speichern zu können als auch kurzfristig hohe Energieflüsse aufnehmen bzw. abgeben zu können.

Beispielsweise kann der erste Energiespeicher eine aufladbare Batterie emulieren und der wenigstens eine zweite Energiespeicheremulator eingerichtet sein, einen Leistungsspeicher, vorzugsweise einen Superkondensator oder Doppelschichtkondensator, zu emulieren.

Gemäß einem weiteren Aspekt der Erfindung kann die Leistungselektronik, die die Energieflüsse zwischen den Energiespeicheremulatoren regelt, zwischen dem Energiespeicheremulator mit der höheren Leistungsdichte und einem Hochvolt-Gleichspannungsnetz (HV-Gleichspannungsnetz) angeordnet sein. Das HV-Gleichspannungsnetz ist vorzugsweise wie ein gängiges Bordnetz von Fahrzeugen mit Traktionsenergiespeichern ausgelegt, d.h. z. B. mit einer Spannung in der Größenordnung von mehreren Hundert Volt betrieben.

Die Testanordnung kann ferner einen Emulator einer weiteren Energiequelle umfassen. Beispielsweise kann die Energiequelle eine Brennstoffzelle, einen Verbrennungsmotor mit Generator und/oder eine Oberleitung, z. B. eine Oberleitung für Busse, die von der Straße aus gespeist werden, umfassen. Ein besonderer Vorteil der Erfindung liegt somit darin, dass die Integration anderer Energiequellen in Form einer Nachbildung möglich ist, um das hybride Energiespeichersystem auch für Auslegungen zu testen, indem eine zusätzliche Energiequelle vorhanden ist.

Es wird betont, dass die vorliegende Erfindung nicht nur zum Entwickeln, Optimieren und/oder Testen von hybriden Energiespeichern möglich ist, sondern dass sich der Erfindungsgedanke auch anwenden lässt, um beliebige Anordnungen aus einem Energiespeicher mit zumindest einer weiteren Energiequelle zu testen und zu optimieren. Im Sinne dieser Beschreibung unterscheidet sich eine Energiequelle von einem Energiespeicher darin, dass eine Energiequelle im Unterschied zum Energiespeicher keine Energieflüsse zur Speicherung aufnehmen kann.

Gemäß einer Abwandlung zu dem vorstehend beschriebenen System betrifft die Erfindung ferner ein System zum Entwickeln und Testen von Energiespeichern. Das System weist eine Testanordnung auf, die umfasst: einen Fahrbetriebsemulator, der eingerichtet ist, einen Energieverbrauch und/oder eine Energieerzeugung eines Fahrbetriebs eines Kraftfahrzeugs zu emulieren; mindestens einen Energiequellenemulator, der eingerichtet ist, eine Energieerzeugung einer Energiequelle für ein Fahrzeugs zu emulieren; einen Energiespeicheremulator, der zur Energieaufnahme und/oder Energieabgabe mit dem Fahrbetriebsemulator und der mindestens einen Energiequelle verbunden ist; und eine Leistungselektronikeinheit, mittels der Energie aus dem Energiespeicheremulator und der ersten Energiequelle dem Fahrbetriebsemulator zuführbar ist und mittels der Energie, die von dem Fahrbetriebsemulator und der mindestens einen Energiequelle erzeugt wird, dem Energiespeicheremulator zuführbar ist.

Hierbei sind der Energiespeicheremulator und die mindestens eine Energiequelle jeweils einrichtbar, durch eine Variation von Parametern unterschiedliche Klassen von Energiespeichern und/oder Energiequellen und/oder unterschiedliche Betriebszustände eines Energiespeichers und/oder einer Energiequelle zu emulieren.

Ferner umfasst die Testanordnung eine Steuerungseinrichtung, die ausgebildet ist, die Leistungselektronikeinheit zu steuern, derart, dass die Steuereinheit der Leistungselektronikeinheit vorgibt, ob ein Energiebedarf des Fahrbetriebsemulators durch den Energiespeicheremulator und/oder durch die mindestens eine Energiequelle bereitgestellt wird und/oder ob eine von dem Fahrbetriebsemulator und/oder von der mindestens einen Energiequelle erzeugte Energie dem Energiespeicheremulator zugeführt wird.

Das System umfasst ferner eine Simulationsvorrichtung, die eingerichtet ist, den Betrieb der Testanordnung für verschiedene Einrichtungen der Steuerungseinrichtung und/oder verschiedene Parametrisierungen des Energiespeicheremulators und/oder der mindestens einen Energiequelle zu simulieren.

Zur Vermeidung von Wiederholungen sollen die vorgenannten Aspekte betreffend das System umfassend den hybriden Energiespeicheremulator auch für die Abwandlung des Systems mit nur einem Energiespeicheremulator als offenbart gelten und beanspruchbar sein.

Ferner betrifft die Erfindung ein Verfahren zum Entwickeln, Optimieren und/oder Testen von hybriden Energiespeichern, unter Verwendung eines Systems gemäß einem der vorgehenden Ansprüche.

Das Verfahren umfasst die folgenden Schritte: Festlegen einer ersten Auslegung der Testanordnung durch eine erste Auswahl der Energiespeicherparameter der Energiespeicheremulatoren und/oder der Steuerungsparameter der Steuerungseinrichtung; und Testen des hybriden Energiespeichers durch Betrieb der Testanordnung der ersten Auslegung, wobei ein Wert einer Zielfunktion bestimmt wird. Die erste Auslegung kann vorzugsweise eine Basisauslegung sein, in der die Betriebsparameter der Energiespeicher beziehungsweise der Energiespeicheremulatoren und die Steuerungsparameter der Steuerungseinrichtung auf typische Werte festgelegt werden, die einen geeigneten Start für die Optimierung darstellen können. Die Startwerte oder Startauslegung können aber auch beliebig gewählt werden.

Bei dem Betrieb der ersten Testauslegung wird ein erster Wert einer Zielfunktion bestimmt. Die Zielfunktion kann in Abhängigkeit von dem Optimierungsziel gewählt werden. Beispielsweise kann die Zielfunktion eine Reichweite des Fahrbetriebs sein, die maximiert werden soll. Vorzugsweise ist die Zielfunktion eine multi-kriterielle Zielfunktion, da ein hybrides Energiespeichersystem oftmals auf verschiedene Anforderungen hin optimiert werden soll.

Nach dem Testen der ersten Auslegung erfolgt eine Variation der Energiespeicherparameter der Energiespeicheremulatoren und/oder eine Variation der Auslegung der Steuerungseinrichtung, beispielsweise durch Variation von Parametern der Steuerungseinrichtung und/oder der Auslegung der Leistungselektronik, um einen erneuten Test des hybriden Energiespeichers durch Betrieb der Testanordnung in der geänderten Auslegung durchzuführen.

Die Variation der Parameter und Durchführung des Testens der Testanordnung erfolgt solange, bis die Zielfunktion einen gewünschten Wert, beispielsweise einen Optimalwert, erreicht hat oder bis ein Abbruchkriterium, beispielsweise eine bestimmte Anzahl von Testdurchläufen, erreicht ist.

Zusammengefasst ermöglicht die vorliegende Erfindung ein schnelles und kosteneffizientes Ermitteln einer optimierten Auslegung eines hybriden Energiesystems. Beispielsweise kann durch Variation der Steuerungsparameter der Steuereinrichtung eine optimierte Ansteuerung der Leistungselektronik ermittelt werden. Ferner kann durch die Variation der Energiespeicherparameter die Anordnung auf z. B. beliebige Batterieparameter hin optimiert werden. So können beispielsweise Energiespeicher mit durch einen Alterungsprozess veränderten Betriebsparametern getestet werden. Ferner ist es möglich, eine Wunschanforderung an die Speicherparameter zu ermitteln. So kann'ein Hersteller einer Steuerungs- und Leistungselektronik, die für seine Steuerung-/Leistungselektronik besonders vorteilhafte Auslegungen des Energiespeichersystems ermitteln und diese an die Energiespeicherhersteller vorgeben.

Weitere Einzelheiten und Vorteile der Erfindung werden im Folgenden unter Bezug auf die beigefügten Zeichnungen beschrieben. Es zeigen:
- Figur 1: ein schematisches Blockschaltbild eines Systems zum Entwickeln und Testen von hybriden Energiespeichern; und
- Figur 2: ein Ablaufdiagramm eines Verfahrens zum Entwickeln und Testen von hybriden Energiespeichern gemäß einem Ausführungsbeispiel.

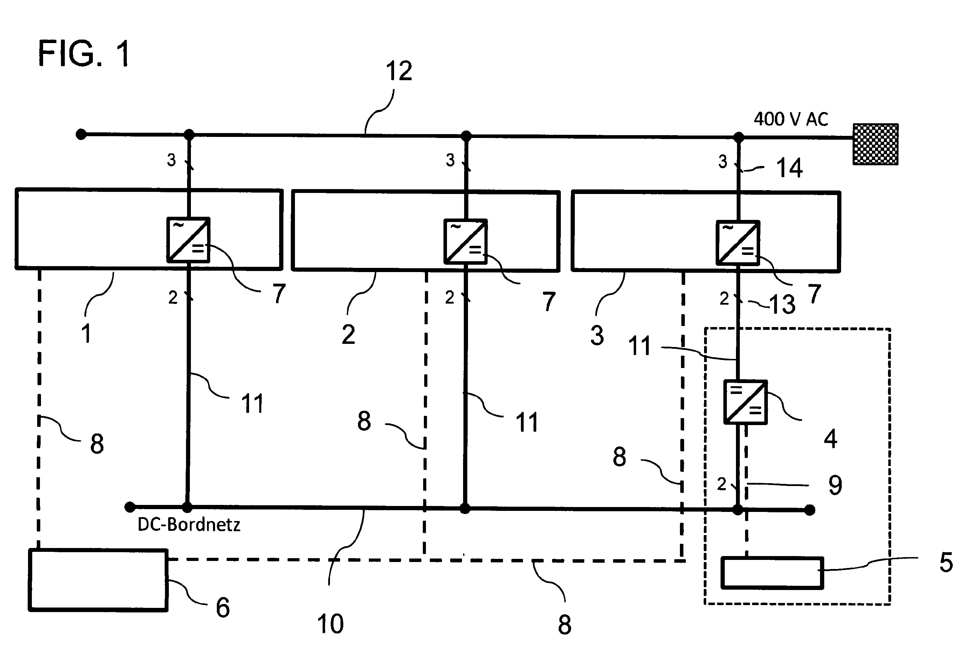

Figur 1 zeigt beispielhaft ein mögliches Ausführungsbeispiel eines Systems, mit den hybride Energiespeicher entwickelt und getestet werden können.

Hierbei ist ein Fahrbetriebsemulator 1 vorgesehen, mit dem der Energieverbrauch und eine Energieerzeugung eines Fahrbetriebs eines Kraftfahrzeugs emuliert wird. Der Fahrbetriebsemulator 1 ist beispielsweise eingerichtet, Fahrwiderstände oder einen Energieverbrauch durch Nebenverbraucher, z. B. der Klimaanlage, und eine Energieerzeugung im Fahrbetrieb, z. B. durch Rekuperationsvorgänge, zu emulieren. Der Energieverbrauch und/oder die Energieerzeugung werden durch eine gesteuerte Leistungselektronik in Form einer DC-Quelle/-Senke 7 dargestellt.

In einem zentralen Echtzeitrechner 6 ist hierzu ein entsprechendes Fahrbetriebsmodell hinterlegt. Im Betrieb der Testanordnung gibt der Echtzeitrechner 6 über eine Steuerleitung 8 der DC-Quelle/-Senke 7 Sollwerte für die Energieerzeugung bzw. den Energieverbrauch vor, so dass die DC-Quelle/-Senke 7 des Fahrbetriebsemulators entsprechende Stromflüsse in den Leitungen 11 erzeugt.

In dem in Figur 1 gezeigten Ausführungsbeispiel bildet somit der Echtzeitrechner 6 mit dem hinterlegten Fahrbetriebsmodell einen Teil der Funktionalität des Fahrbetriebsemulators 1 aus. Es besteht jedoch auch die Möglichkeit, das Fahrbetriebsmodell und die zugeordnete Steuerung direkt in einer baulichen Einheit zu integrieren.

Die Testanordnung umfasst ferner einen Emulator eines hybriden Energiespeichers, der einen ersten Energiespeicheremulator 2 und einen zweiten Energiespeicheremulator 3 sowie die Leistungselektronikeinheit 4 umfasst. Der hybride Energiespeicher ist mit dem Fahrbetriebsemulator 1 zur Energieaufnahme und/oder Energieabnahme über die Stromleitungen 11 verbunden.

Der Energiespeicheremulator 2 umfasst neben der ansteuerbaren DC-Quelle/-Senke 7 ein Energiespeichermodell des emulierte ersten Energiespeichers, das in dem Echtzeitrechner hinterlegt ist. Der Echtzeitrechner 6 dient auch als Steuerung, um die DC-Quelle/-Senke 7 des Energiespeicheremulators 2 in Abhängigkeit von dem zugeordneten Energiespeichermodell über eine Signalleitung 8 zu steuern.

Hierfür werden Strom und gegebenenfalls weitere Größen an der DC-Klemme der DC-Quelle/-Senke 7 gemessen. Dieser Messwert dient als Eingangsgröße für das hinterlegte Energiespeichermodell. Aus den Eingangsgrößen errechnet der Echtzeitrechner 6 mit dem Energiespeichermodell des ersten Energiespeichers die Reaktion eines realen Speichers auf den gemessenen Lade- und/oder Entladevorgang. Das entsprechende Verhalten der Klemmenspannung wird dann als Sollwert der DC-Quelle/-Senke 7 vorgegeben. In diesem Ausführungsbeispiel ist somit ein Teil der Funktionalität des ersten Energiespeicheremulators, nämlich das Energiespeichermodell und die Steuerung, zentral im Rechner 6 ausgebildet.

Es wurde bereits erwähnt, dass die Funktionalität des ersten Energiespeicheremulators 2 baulich in einer Komponente integriert sein kann.

Der zweite Energiespeicheremulator 3 ist in analoger Weise zum ersten Energiespeicher 2 mit einer steuerbaren DC-Quelle/-Senke 7 ausgebildet. Im Echtzeitrechner 6 ist wiederum ein Energiespeichermodell des zweiten Energiespeichers hinterlegt, so dass, wie zuvor für den ersten Energiespeicheremulator beschrieben, der Echtzeitrechner 6 die DC-Quelle/- Senke 7 steuert, so dass diese die Energieflüsse, die der zweite Energiespeicher aufnehmen bzw. abgeben würde, nachbildet.

Die Emulatoren 1, 2 und 3 speisen sich aus einem Wechselspannungsnetz 12, das im vorliegendem Ausführungsbeispiel das herkömmliche öffentliche AC-Netz mit 400 Volt Netzspannung ist. Das Netz 12 dient dazu, die von den Emulatoren 1, 2 und 3 abgegebene Energie bzw. Ströme bereitzustellen und die von den Emulatoren 1, 2 und 3 aufgenommenen Energieflüsse bzw. Ströme aufzunehmen, da die Emulatoren selbst keine Energie speichern.

Die mit dem Bezugszeichen 14 bezeichnete Markierung bezeichnet die dreiphasigen Anschlüsse des AC-Netzes, während die mit dem Bezugszeichen 13 bezeichnete Markierung die zweiphasigen Anschlüsse (+/-) des DC-Netzes anschließt.

Die Emulatoren 1, 2 und 3 sind an einem Gleichspannungsnetz 10 angeschlossen, das mit einer typischen Spannung eines Bordnetzes von Hybridfahrzeugen oder E-Fahrzeugen betrieben ist. Typische Spannungen des Gleichspannungsnetzes 10 liegen im Bereich von mehreren hundert Volt, um die hohen Leistungen im Fahrbetrieb aufnehmen bzw. bereitstellen zu können.

Der hybride Energiespeicher umfasst ferner eine Leistungselektronik 4, die die Energieflüsse zwischen den beiden Emulatoren 2 und 3 steuert. Die Leistungselektronik 4 entspricht einer aus der Praxis bekannten Leistungselektronik, die zur Steuerung der Energieflüsse zwischen zwei Hybridspeichern angeordnet ist. Die Leistungselektronik 4 ist daher eingerichtet, Energie dem ersten und zweiten Energiespeicheremulator zuzuführen und Energie aus dem ersten und den zweiten Energiespeicheremulator zu entnehmen.

Die Leistungselektronik 4 wird von einem Steuergerät 5 gesteuert, das über eine Steuerleitung 9 mit der Leistungselektronik 4 verbunden ist. Die Leistungselektronik 4 kann somit die Energie, die von den nachgebildeten Energiespeichern abgegeben oder aufgenommen werden soll, auf die Energiespeicheremulatoren verteilen. Wie die Energieflüsse gesteuert werden, ist abhängig von zusätzlichen Eingangsdaten am Steuergerät 5. Z. B. sind die SoC (= State of Charge = Ladezustand) der Energiespeicheremulatoren eine weitere Eingangsgröße. Diese können entweder direkt vom Steuergerät 5 mittels entsprechender Sensorik (nicht gezeigt) erfasst oder via Datenbus an das Steuergerät 5 gesendet werden. Durch die Steuerung der Energieflüsse kann ein hybrider Energiespeicher für verschiedene Anwendungsfälle hin optimiert werden.

In Abhängigkeit der erfassten Energieflüsse gibt das Steuergerät 5 der Leistungselektronikeinheit 4 vor, aus welchen der Energiespeicheremulatoren 2, 3 Energie für den Fahrbetriebsemulator bereitgestellt wird und/oder in welchen der Energiespeicheremulatoren 2, 3 vom Fahrbetriebsemulator 1 erzeugte Energie zugeführt wird. Hierzu sendet das Steuergerät 5 Steuersignale über die Steuerleitung 9 an die Leistungselektronikeinheit 4. In Abhängigkeit der Steuersignale werden die Leistungsschalter in der Leistungselektronikeinheit 4 betätigt.

Die Anordnung aus Leistungselektronikeinheit 4 und Steuereinheit 5 kann auch als eine bauliche Einheit ausgebildet sein, was mit der gestrichelten Linie illustriert ist.

Im vorliegendem Beispiel wird durch den ersten Emulator 2 ein Speicher mit hoher Energiedichte, beispielsweise eine Batterie, emuliert und mit dem zweiten Energiespeicher 3 ein Energiespeicher mit hoher Leistungsdichte, beispielsweise ein Doppelschichtkondensator.

Die Klasse des Energiespeichers, beispielsweise ob eine Batterie oder ein Superkondensator emuliert wird, und die konkrete Auslegung eines Speichers, beispielsweise die konkrete Leistungs- und Energiedichte, der Ladungszustand oder die Reaktionszeit des Speichers werden durch Festlegung entsprechender Energiespeicherparameter bestimmt, die als einstellbare Parameter in dem Energiespeichermodell abgebildet sind.

Die beschriebene Testanordnung kann nun für verschiedene Parametrisierungen getestet werden. Hierfür ist eine Simulationsvorrichtung vorgesehen, die den Betrieb der hybriden Energiespeicher 2, 3 mittels der Testanordnung für verschiedene Steuerungsparameter und/oder verschiedene Energiespeicherparameter simuliert. Vorliegend wird wiederum der Echtzeitrechner 6 als Simulationsvorrichtung benutzt.

Der Rechner 6 gibt für verschiedene Testdurchläufe verschiedene Parametereinstellungen der emulierten Energiespeicher vor, um für jede Parametereinstellung das Verhalten der Energiespeicheremulatoren 2, 3 gemäß der Steuerung durch das Steuergerät 5 in Reaktion auf einen Energieverbrauch und/oder eine Energieerzeugung eines durch den Fahrbetriebsemulator 1 abgebildeten Fahrbetriebs zu überwachen und auszuwerten.

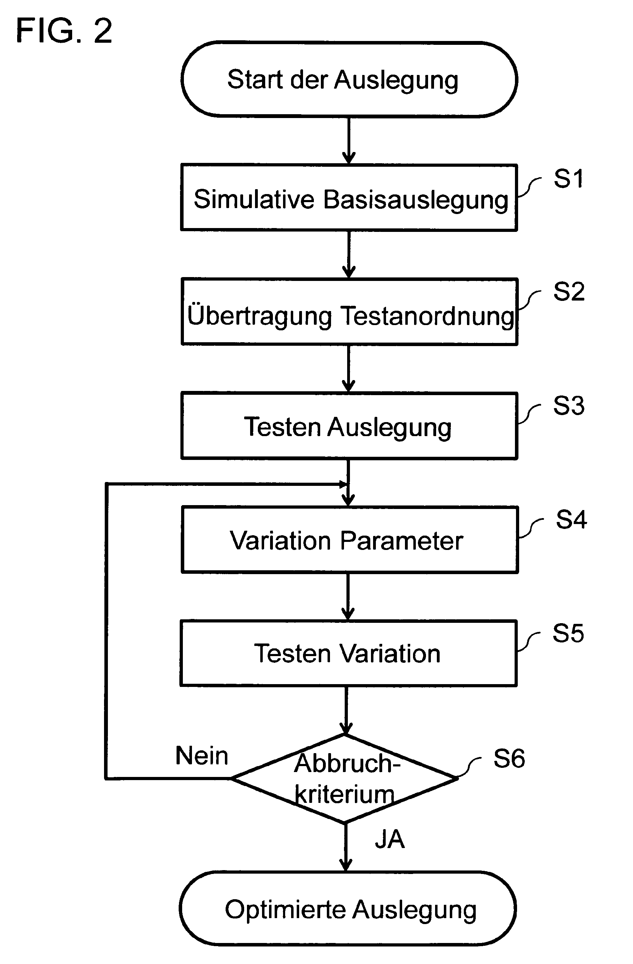

Dies ist nachfolgend anhand der Figur 2 beispielhaft erläutert.

In einem ersten Schritt S1 erfolgt eine simulative Basisauslegung, bei der eine erste Parametrisierung erfolgt. Hierbei werden die Energiespeicherparameter in den Energiespeichermodellen in einer ersten Auslegung festgelegt.

Soll beispielsweise eine optimierte Steuerung 5 für einen Hybridspeicher mit einer Batterie und einem Doppelschichtkondensator getestet werden, werden die Energiespeicherparameter Energiedichte und Leistungsdichte für den ersten Energiespeicher 2 so gewählt, dass dieser eine Batterie mit vorgegebener Leistungs- und Energiedichte emuliert, und für den Emulator 3 so gewählt, dass dieser einen Doppelschichtkondensator mit vorgegebener Leistungs- und Energiedichte emuliert.

Für eine Basisauslegung des Steuergeräts 5 wird ein erstes Steuerverfahren für die Steuerung der Leistungselektronikeinheit 4 gewählt, um das Steuergerät 5 für einen ersten Betrieb einzurichten. Hierbei kann beispielsweise ein bisher verwendetes Steuerverfahren als Startpunkt verwendet werden.

In Schritt S2 wird die gewählte Parametrisierung der Energiespeicher 2, 3 und des Steuergeräts 5 auf die Testanordnung übertragen. Hierbei werden die in dem Echtzeitrechner 6 hinterlegten Energiespeichermodelle mit den Parametern der Basisauslegung parametrisiert und das Steuergerät 5 eingerichtet, das ausgewählte Steuerverfahren durchzuführen.

Anschließend erfolgt in Schritt S3 ein Testen der Auslegung. Hierzu startet der Echtzeitrechner 6 den Fahrbetriebsemulator, der ein Fahrbetrieb emuliert und dabei einen typischen zeitlichen Ablauf des Energieverbrauches und einer Energieerzeugung eines Kraftfahrzeugs vorgibt. Aufgrund der von dem Fahrbetriebsemulator erzeugten Energieflüsse gibt das Steuergerät gemäß dem hinterlegten Steuerverfahren an die Leistungselektronik 4 vor, durch welchen der beiden Energiespeicheremulatoren 2, 3 ein Energiebedarf des Fahrbetriebsemulators 1 bedient wird. Ferner entscheidet das Steuergerät 5 bei einem Energieeintrag des Fahrbetriebsemulators 1, welchem der beiden DC-Quellen/-Senken 7 der Energiespeicheremulatoren 2, 3 die Leistungselektronik 4 die erzeugte Energie zuführen soll.

Gemäß der hinterlegten Energiespeichermodelle geben die Energiespeicheremulatoren 2, 3 in Abhängigkeit der Steuerung durch die Leistungselektronik 4 Strom ab oder nehmen Strom auf.

Die Simulationsvorrichtung 6 in Form des Echtzeitrechners erfasst während des Testvorgangs verschiedene Messdaten, die zur Auswertung für eine vorbestimmte Zielfunktion benötigt werden, nach denen die Simulationsvorrichtung die Qualität der Steuerung durch die Steuerungseinheit 5 beurteilt.

Anschließend erfolgt in Schritt S5 eine Variation der Auslegung der Testanordnung. Hierbei besteht im Rahmen der Erfindung die Möglichkeit, sowohl die Parametrisierung der Energiespeicher zu ändern, z. B. um das Verhalten des hybriden Energiespeichers bei verschiedenen Alterungszuständen zu testen, als auch das Steuergerät 5 einzurichten, um verschiedene Steuerungsverfahren durchzuführen.

Für jede der Variationen der Auslegung der Testanordnung folgt dann ein erneutes Testen in Schritt S6, wie zuvor in Schritt S4 für die Basisauslegung beschrieben.

Die Variation der Steuerungsparameter und das Testen der modifizierten Steuerung der Leistungselektronik können solange wiederholt werden, bis eine optimale Einrichtung der Steuerung 5 ermittelt wurde, beispielsweise gekennzeichnet durch einen Optimalwert der Zielfunktion. Alternativ kann auch ein vorbestimmtes Abbruchkriterium vorgegeben werden, beispielsweise eine bestimmte Anzahl von Wiederholungen, nach denen die Schritte S5 und S6 abgebrochen werden und nach denen die Ergebnisse für die einzelnen Testbetriebe mit unterschiedlichen Auslegungen ausgewertet werden können.

Das Testverfahren, insbesondere die Schritte S1 bis S6, können in analoger Weise auch für die abgewandelte Testanordnung mit nur einem Energiespeicheremulator und mindestens einer Energiequelle durchgeführt werden.

Obwohl die Erfindung unter Bezugnahme auf bestimmte Ausführungsbeispiele beschrieben worden ist, ist eine Vielzahl von Varianten und Abwandlungen möglich, die ebenfalls von dem Erfindungsgedanken Gebrauch machen und deshalb in den Schutzbereich fallen. Folglich soll die Erfindung nicht auf die offenbarten bestimmten Ausführungsbeispiele begrenzt sein, sondern die Erfindung soll alle Ausführungsbeispiele umfassen, die in den Bereich der beigefügten Patentansprüche fallen.

### Bezugszeichenliste

- 1: Fahrbetriebsemulator
- 2: Erster Energiespeicheremulator
- 3: Zweiter Energiespeicheremulator
- 4: Leistungselektronikeinheit
- 5: Steuerungseinrichtung
- 7: Steuerbare DC-Quelle/-Senke
- 8, 9: Steuerleitungen
- 10: DC-Netz
- 11: Stromleitung
- 12: AC-Netz
- 13: 2-phasige Anschlüsse DC-Netz
- 14: 3-phasige Anschlüsse AC-Netz

## Patentansprüche

1. System zum Entwickeln und Testen von hybriden Energiespeichern, mit einer Testanordnung und einer Simulationsvorrichtung;
wobei die Testanordnung umfasst:
(a) einen Fahrbetriebsemulator (1), der eingerichtet ist, einen Energieverbrauch und/oder eine Energieerzeugung eines Fahrbetriebs eines Kraftfahrzeugs zu emulieren;
(b) einen Emulator eines hybriden Energiespeichers, der mit dem Fahrbetriebsemulator zur Energieaufnahme und/oder Energieabgabe verbunden ist, umfassend:
einen ersten Energiespeicheremulator (2),
wenigstens einen zweiten Energiespeicheremulator (3), und
eine Leistungselektronikeinheit (4), mittels der Energie in den ersten (2) und den wenigstens zweiten Energiespeicheremulator (3) zuführbar ist und mittels der Energie aus dem ersten (2) und dem zweiten (3) Energiespeicheremulator entnehmbar ist;
wobei die Energiespeicheremulatoren (2, 3) jeweils einrichtbar sind, durch eine Variation von Energiespeicherparametern unterschiedliche Klassen von Energiespeichern und/oder unterschiedliche Betriebszustände eines Energiespeichers zu emulieren; und
(c) eine Steuerungseinrichtung (5), die ausgebildet ist, die Leistungselektronikeinheit (4) zu steuern, derart, dass die Steuereinheit (5) der Leistungselektronikeinheit (4) vorgibt, aus welchen der Energiespeicheremulatoren (2, 3) Energie für den Fahrbetriebsemulator (1) bereitgestellt wird und/oder welchem der Energiespeicheremulatoren (2, 3) vom Fahrbetriebsemulator (1) erzeugte Energie zugeführt wird; wobei die Steuerungseinrichtung (5) einrichtbar ist, unterschiedliche Steuerungsverfahren durchzuführen; und
wobei die Simulationsvorrichtung (6) eingerichtet ist, den Betrieb von hybriden Energiespeichern mittels der Testanordnung für verschiedene Einrichtungen der Steuerungseinrichtung (5) und/oder verschiedene Energiespeicherparameter zu simulieren.

2. System nach Anspruch 1, **dadurch gekennzeichnet, dass** die Energiespeicherparameter zumindest einen der folgenden Parameter des Energiespeichers umfassen: Energiedichte, Leistungsdichte, Speicherkapazität und Ladezustand (SoC).

3. System nach Anspruch 1 oder 2, **dadurch gekennzeichnet, dass** der erste Energiespeicheremulator und/oder der wenigstens eine zweite Energiespeicheremulator eine steuerbare DC-Quelle/-Senke (7), ein Energiespeichermodell und eine Steuerung umfasst, wobei die Steuerung die DC-Quelle/-Senke in Abhängigkeit des Energiespeichermodells steuert.

4. System nach Anspruch 3, **gekennzeichnet durch** einen Rechner (6), in dem die Energiespeichermodelle für die emulierten Energiespeicher des hybriden Energiespeichers hinterlegt sind und der über Signalleitungen (8) jeweils mit der DC-Quelle/-Senke (7) der Energiespeicheremulatoren (2, 3) verbunden ist, wobei der Rechner (6) eingerichtet ist, über die Signalleitungen (8) einen an der DC-Klemme der DC-Quelle/-Senke (7) gemessenen Stromwert als Eingangsgröße für das hinterlegte Energiespeichermodell des zugeordneten emulierten Energiespeichers zu erfassen und in Abhängigkeit von dem hinterlegten Energiespeichermodell und dem gemessenen Stromwert eine Reaktion des emulierten Energiespeichers auf den gemessenen Lade- oder Entladevorgang in Form eines Sollwerts für die DC-Klemmenspannung an die steuerbare DC-Quelle/-Senke (7) vorzugeben.

5. System nach Anspruch 4, **dadurch gekennzeichnet, dass** der Rechner (6) ferner eingerichtet ist, als die Simulationsvorrichtung (6) betrieben zu werden, wobei mittels einer Variation von Energiespeicherparametem in den hinterlegten Energiespeichermodellen der Betrieb von hybriden Energiespeichern mittels der Testanordnung für verschiedene Energiespeicherparameter simulierbar ist.

6. System nach einem der vorhergehenden Ansprüche, **dadurch gekennzeichnet, dass** der erste Energiespeicheremulator (2) eingerichtet ist, einen Energiespeicher mit höherer Energiedichte und kleinerer Leistungsdichte als der wenigstens eine zweite Energiespeicheremulator (3) zu emulieren.

7. System nach Anspruch 6, **dadurch gekennzeichnet, dass** der erste Energiespeicheremulator (2) eingerichtet ist, eine aufladbare Batterie zu emulieren, und der wenigstens eine zweite Energiespeicheremulator (3) eingerichtet ist, einen Leistungsspeicher, vorzugsweise einen Superkondensator oder Doppelschichtkondensator, zu emulieren.

8. System nach Anspruch 6 oder 7, **dadurch gekennzeichnet, dass** die Leistungselektronik (4) zwischen dem Energiespeicheremulator (3) mit der höheren Leistungsdichte und einem Gleichspannungsnetz angeordnet ist, wobei das Gleichspannungsnetz mit der Spannung des Bordnetzes der zu testenden Fahrzeugumgebung betrieben wird.

9. System nach einem der vorhergehenden Ansprüche, **dadurch gekennzeichnet, dass** der Fahrbetriebsemulator (1)
(a) durch eine gesteuerte Leistungselektronik emuliert ist, oder
(b) durch einen Fahrantrieb, der gegen eine Belastungsmaschine betrieben wird, emuliert ist.

10. System nach einem der vorhergehenden Ansprüche, **dadurch gekennzeichnet, dass** die Testanordnung ferner einen Emulator einer Energiequelle umfasst.

11. System nach Anspruch 10, **dadurch gekennzeichnet, dass** die Energiequelle eine Brennstoffzelle, einen Verbrennungsmotor mit Generator und/oder eine Oberleitung umfasst.

12. System zum Entwickeln und Testen von Energiespeichern, mit einer Testanordnung und einer Simulationsvorrichtung;
wobei die Testanordnung umfasst:
(a) einen Fahrbetriebsemulator, der eingerichtet ist, einen Energieverbrauch und/oder eine Energieerzeugung eines Fahrbetriebs eines Kraftfahrzeugs zu emulieren;
(b) mindestens einen Energiequellenemulator, der eingerichtet ist, eine Energieerzeugung einer Energiequelle für ein Fahrzeugs zu emulieren;
(c) einen Energiespeicheremulator, der zur Energieaufnahme und/oder Energieabgabe mit dem Fahrbetriebsemulator und der mindestens einen Energiequelle verbunden ist; und
(d) eine Leistungselektronikeinheit, mittels der Energie aus dem Energiespeicheremulator und der ersten Energiequelle dem Fahrbetriebsemulator zuführbar ist und mittels der Energie, die von dem Fahrbetriebsemulator und der mindestens einen Energiequelle erzeugt wird, dem Energiespeicheremulator zuführbar ist;
wobei der Energiespeicheremulator und die mindestens eine Energiequelle jeweils einrichtbar sind, durch eine Variation von Parametern unterschiedliche Klassen von Energiespeichern und/oder Energiequellen und/oder unterschiedliche Betriebszustände eines Energiespeichers und/oder einer Energiequelle zu emulieren; und
(e) eine Steuerungseinrichtung, die ausgebildet ist, die Leistungselektronikeinheit zu steuern, derart, dass die Steuereinheit der Leistungselektronikeinheit vorgibt, ob ein Energiebedarf des Fahrbetriebsemulators durch den Energiespeicheremulator und/oder durch die mindestens eine Energiequelle bereitgestellt wird und/oder ob eine von dem Fahrbetriebsemulator und/oder von der mindestens einen Energiequelle erzeugte Energie dem Energiespeicheremulator zugeführt wird;
wobei die Simulationsvorrichtung eingerichtet ist, den Betrieb der Testanordnung für verschiedene Einrichtungen der Steuerungseinrichtung und/oder verschiedene Parametrisierungen des Energiespeicheremulators und/oder der mindestens einen Energiequelle zu simulieren.

13. Verfahren zum Entwickeln und Testen von Energiespeichern, mit einem System gemäß einem der vorhergehenden Ansprüche 1 bis 11, wobei das Verfahren die folgenden Schritte umfasst:
(a) Festlegen einer ersten Auslegung der Testanordnung durch eine erste Auswahl der Energiespeicherparameter der Energiespeicheremulatoren und/oder eine erste Einrichtung der Steuerungseinrichtung (S1);
(b) Testen des hybriden Energiespeichers durch Betrieb der Testanordnung in der ersten Auslegung, wobei ein Wert einer Zielfunktion bestimmt wird (S3);
(c) Wiederholtes Festlegen veränderter Auslegungen der Testanordnung durch Variation der Energiespeicherparameter der Energiespeicheremulatoren und/oder durch Variation der Einrichtung der Steuerungseinrichtung und wiederholtes Testen der veränderten Auslegungen der Testanordnung bis ein Wert der Zielfunktion einen vorbestimmten Wert erreicht und/oder ein Abbruchkriterium erreicht ist (S4-S6).
